Europäisches Patentamt

(19) European Patent Office

Office européen des brevets

(11) Numéro de publication : **0 285 499 B1**

(12) **FASCICULE DE BREVET EUROPEEN**

(45) Date de publication du fascicule du brevet :
26.06.91 Bulletin 91/26

(51) Int. Cl.[5] : **C30B 31/22**, G02B 6/12, G02F 1/03

(21) Numéro de dépôt : **88400685.9**

(22) Date de dépôt : **22.03.88**

(54) **Procédé pour augmenter localement les indices de réfraction d'un matériau électro-optique utilisable en optique guidée et matériau obtenu par ce procédé.**

(30) Priorité : **25.03.87 FR 8704143**

(43) Date de publication de la demande :
**05.10.88 Bulletin 88/40**

(45) Mention de la délivrance du brevet :
**26.06.91 Bulletin 91/26**

(84) Etats contractants désignés :
**DE GB NL**

(56) Documents cités :
**US-A- 4 547 262**
**PHYSICA STATUS SOLIDI (A), vol. 88, no. 1, 1985, pages 193-205, Berlin, DE; S. JETSCHKE et al.: "Diffusion and recrystallization processes during annealing of N+- and P+-implanted LiNbO3"**
**JOURNAL OF APPLIED PHYSICS, vol. 50, no. 12, décembre 1979, pages 7818-7905, American Institute of Physics, New York, US; B.W. FARMERY et al.: "The formation of waveguides and modulators in LiNbO3 by ion implantation"**

(56) Documents cités :
**JOURNAL OF LIGHTWAVE TECHNOLOGY, vol. LT-3, no. 4, août 1985, pages 855-859, IEEE, New York, US; J.M. NADEN et al.: "Optical properties of planar waveguides formed by He+ implantation in LiNbO3"**

(73) Titulaire : **ETAT FRANCAIS représenté par le Ministre Délégué des Postes et Télécommunications (CENTRE NATIONAL D'ETUDES DES TELECOMMUNICATIONS) 38-40 rue du Général Leclerc F-92131 Issy-les-Moulineaux (FR)**

(72) Inventeur : **Carenco, Alain 4, rue Paul-Henry Thilloy F-92340 Bourg-la-Reine (FR)**
Inventeur : **Rao, Elchuri 1, rue du Moulin de Pierre F-92130 Issy les Moulineaux (FR)**
Inventeur : **Fouchet, Sylvie 13, rue Baillou F-75014 Paris (FR)**

(74) Mandataire : **Mongrédien, André et al c/o BREVATOME 25, rue de Ponthieu F-75008 Paris (FR)**

## Description

La présente invention a pour objet un procédé pour augmenter localement les indices de réfraction d'un matériau monocristallin ferroélectrique, ayant des propriétés électro-optiques. Elle trouve une application dans le domaine de l'optique guidée pour la réalisation de guides de lumière et de composants optiques discrets ou intégrés, tels que des lentilles, des modulateurs électro-optiques, des réseaux de diffraction, des multiplexeurs.

Les techniques de traitement et/ou de transmission à distance de l'information étudiées depuis quelques années, notamment dans le domaine des télécommunications, utilisent la transmission par ondes lumineuses dans des guides de lumière à structure plane. Ces guides de lumière sont constitués d'une couche guidante, intercalée entre deux milieux présentant des indices de réfraction inférieurs à celui ou ceux de la couche guidante. L'air constitue généralement l'un des deux milieux.

A chaque guide optique monomode, on associe un indice effectif $n_{eff}=c/v$, où v représente la vitesse de propagation de la lumière dans la couche guidante et c la vitesse de propagation de la lumière dans le vide. La valeur de l'indice effectif dépend de la valeur des différents indices des couches constituant le guide de lumière ainsi que de leur épaisseur. Il en résulte en optique guidée que la vitesse d'une onde lumineuse peut être modifiée soit par des variations d'indices des différentes couches en présence, soit par des variations de leur épaisseur.

Parmi les matériaux ferroélectriques, présentant par conséquent des propriétés électro-optiques, le niobate de lithium ($LiNbO_3$) est actuellement le matériau le plus utilisé en optique guidée. Il s'agit d'un cristal uni-axe, donc biréfringent, comportant deux indices principaux, l'un suivant l'axe du cristal, appelé indice extraordinaire $n_e$ et l'autre, dans un plan perpendiculaire au premier, appelé indice ordinaire $n_o$.

Actuellement, on dispose de trois techniques pour modifier localement les indices de réfraction $n_e$ et $n_o$ d'un monocristal en niobate de lithium.

La première technique a trait à la diffusion d'un dopant métallique, dans le monocristal. Cette technique consiste à déposer à la surface du cristal une couche de dopant métallique, de quelques nanomètres d'épaisseur (50 à 100 nm), puis à soumettre l'ensemble à un recuit, pendant quelques heures, à une température voisine de 1000°C pour permettre la diffusion du dopant métallique dans le monocristal.

Cette technique est en particulier décrite dans un article de Appl. Phys. Lett. vol. 25, n°8, pages 458-460 de 1974, intitulé "Metal-diffused optical waveguides in $LiNbO_3$" de R.V. Schmidt.

La diffusion des ions dopants est en général effectuée sous atmosphère d'oxygène, d'argon ou d'azote.

Cette technique de diffusion permet la création en surface du $LiNbO_3$ d'une couche guidante présentant une augmentation d'au plus $+2.10^{-2}$ de l'indice extraordinaire et d'au plus $+10^{-2}$ de l'indice ordinaire par rapport au cristal non dopé. Cette technique permet d'obtenir directement des guides optiques de surface, parfaitement stables et ayant de faibles pertes de propagation lumineuse (de l'ordre de 0,1 dB/cm). En outre, ces guides sont utilisables pour toutes les polarisations de la lumière. La couche guidante est assez profonde et présente une épaisseur de 3 à 20 micromètres typiquement.

La technique de diffusion utilise des dopants métalliques, c'est-à-dire des atomes susceptibles de prendre la place d'un cation du réseau cristallin du matériau. En d'autres termes, la diffusion de dopants modifie localement la composition du monocristal. Les dopants utilisés sont en particulier le titane, l'or, l'argent, le fer, le cobalt, le niobium, le cuivre, le tantale, le vanadium et le nickel pour un monocristal en $LiNbO_3$ et le titane, le niobium et le cuivre pour un monocristal en $LiTaO_3$.

Cette technique de diffusion, qui est actuellement la plus utilisée pour réaliser des guides optiques, présente un certain nombre d'inconvénients.

En particulier, cette technique ne permet l'obtention que de guides à gradient d'indice, le dopant diffusant plus ou moins et assez profondément dans le monocristal ; elle ne permet pas la réalisation de guides à saut d'indice, c'est-à-dire de guides ayant une couche guidante d'indices de réfraction bien déterminés par rapport à ceux du monocristal non dopé et d'épaisseur finie. Le profil de diffusion des dopants est fonction de la température de recuit, du temps de recuit et de l'épaisseur de la couche de dopant déposée ; il n'a donc pas de frontière abrupte dans le substrat.

De plus, du fait de la diffusion latérale importante, la technique de diffusion ne permet pas, en particulier, la réalisation de réseaux de diffraction dont les pas varient de 0,1 à 0,4 micromètre.

En outre, l'augmentation des indices ordinaire et extraordinaire est faible (de l'ordre de $10^{-2}$). Ceci est en particulier dû à la faible quantité de dopants susceptible d'être introduite dans le monocristal par diffusion.

La seconde technique servant à modifier localement les indices de réfraction d'un matériau concerne les échanges d'ions qui sont tous assimilables à un échange protonique. Cette technique est notamment décrite dans un article de Optics Letters vol. 8, n°2, de février 1983, pp. 114-115, intitulé "Independent control of index and profiles in proton-exchanged lithium niobate guides" de M. de Micheli et al.

Cette technique permet, à l'inverse de la précédente, la réalisation de guides optiques à saut d'indice. En outre, cette technique permet une forte augmentation de l'indice extraordinaire du niobate de lithium (+0,12). En revanche, le guidage de la lumière ne peut pas utiliser la polarisation correspondant à l'indice extraordinaire $n_o$ du matériau puisque la variation de cet indice est négative (de l'ordre de −0,05).

Par ailleurs, les guides obtenus ont l'inconvénient d'être instables avec le temps. A cet effet, on peut se référer à l'article de Appl. Phys. Lett., vol. 42, n°8 du 15 avril 1983, pp. 633-635, intitulé "Index instabilities in proton-exchanged LiNbO$_3$ waveguides" d'Alfredo Yi-Yan.

La troisième technique utilisée en optique guidée est l'implantation ionique de diverses impuretés telles que les ions H$^+$, He$^+$, B$^+$, N$^+$, O$^+$, Ne$^+$, P$^+$, Ar$^+$. Cette technique d'implantation ionique est notamment décrite dans l'article de J. Appl. Phys. 50 (12), de décembre 1979 de J.L. Destefanis, intitulé "The formation of waveguides and modulators in LiNbO$_3$ by ion implantation", pp. 7898-7905, et dans l'article de Journal of Lightwave Technology, vol. LT-3, n°4 d'août 1985 de J. Mark Naden et al., pp. 855-858, intitulé "Optical properties of planar waveguides formed by He$^+$ implantation in LiNbO$_3$".

L'implantation ionique d'impuretés crée des défauts dans le réseau cristallin, entraînant une augmentation de la maille du cristal du fait du désordre induit. Elle crée, en outre, une diminution de l'indice tant ordinaire qu'extraordinaire dans une couche enterrée du monocristal. La couche guidante est alors définie entre la couche implantée dans le matériau et l'air.

L'implantation ionique a l'avantage de permettre à la fois une localisation précise de la couche enterrée et un bon contrôle de la quantité d'impuretés introduites dans cette couche, à l'inverse de la diffusion. Elle permet donc la réalisation de guides optiques à saut d'indice.

Afin de réarranger le réseau cristallin de la couche guidante, perturbé lors de l'implantation, cette dernière est généralement suivie d'un recuit allant de 200 à 400°C. Un recuit à une température plus élevée et en particulier supérieure à 600°C conduit à une guérison des défauts de la couche implantée, annihilant la variation d'indice de réfraction obtenue lors de l'implantation, et donc à la destruction du guide optique. Ceci apparaît clairement dans l'article ci-dessus de Destefanis.

La technique d'implantation, à l'inverse des deux techniques précédentes ne permet qu'une diminution des indices de réfraction limitant considérablement son utilisation pour la réalisation de guides et/ou de composants optiques. En particulier, cette technique ne permet pas l'augmentation des indices de réfraction ordinaire et extraordinaire à la surface du substrat.

La technique de diffusion ainsi que celle d'implantation, comportant des étapes de chauffage, provoquent généralement une exodiffusion du lithium. Cette exodiffusion provoque une augmentation de l'indice extraordinaire à la surface du matériau, alors que l'indice ordinaire n'est pas modifié. Ceci contribue fortement à l'augmentation de l'indice extraordinaire dans la technique de diffusion.

En revanche, cette exodiffusion vient compenser la diminution de l'indice extraordinaire due à l'implantation ionique annihilant fortement le but recherché par l'implantation, pour l'indice extraordinaire, tandis que l'indice ordinaire reste négatif.

En outre, après recuit du matériau implanté, la région implantée du matériau reste le siège d'une migration de lithium, qui est importante, même à température ambiante conduisant à l'obtention de guides optiques peu stables dans le temps.

Le phénomène d'exodiffusion du lithium, dans le cas d'une implantation d'impuretés suivie d'un recuit, a notamment été décrit dans un article de Phys. Stat. Sol. (a) 88, 193 (1985), intitulé "Diffusion and recrystallization processes during annealing of N$^+$ and P$^+$ implanted LiNbO$_3$" de S. Jetschke, pp 193-205.

Par ailleurs, dans la technique d'implantation ionique, on a envisagé d'implanter des ions métalliques, notamment de titane et d'argent dans le niobate de lithium comme décrit dans l'article ci-dessus de Destefanis. Cette implantation a été suivie d'un recuit à haute température, et en particulier de 970°C comme l'enseigne la thèse de Destefanis présentée à l'Université Scientifique et Médicale de Grenoble et à l'Institut National Polytechnique de Grenoble le 26 septembre 1978, intitulée "Etude de la modification des propriétés optiques induites par implantation ionique dans le LiNbO$_3$. Application à la réalisation de guides d'ondes".

Cette implantation ionique, suivie du recuit à haute température, a permis d'augmenter en surface l'indice extraordinaire du LiNbO$_3$ monocristallin de façon identique à celle obtenue par la technique de diffusion habituelle du titane dans ce substrat.

Dans ce procédé, la couche de surface implantée à faible énergie (130 keV), ne pouvant permettre la propagation de la lumière car d'indice plus faible que le substrat, n'a servi que de source de diffusion du titane. Le titane n'est pas resté dans le site d'implantation et, sous l'effet de la température élevée, il a migré en se diluant sur une profondeur de plusieurs micromètres, de la même manière que lors d'une diffusion à partir d'une couche mince de titane déposée à la surface du monocristal.

La présente invention a donc pour objet un procédé pour augmenter localement les indices de réfraction d'un matériau électro-optique permettant de remédier aux différents inconvénients donnés ci-dessus.

Cette augmentation, qui concerne tout ou partie du matériau électro-optique, permet la réalisation directe d'un guide optique ainsi que la réalisation d'une perturbation locale des indices de la couche guidante permettant ainsi la réalisation de composants optiques.

Ce procédé permet, à l'inverse de la technique de diffusion d'un dopant métallique, la réalisation de guides à saut d'indice, de bonne qualité optique, présentant une augmentation importante des indices du matériau ferro-électrique, d'au moins +0,1.

Par ailleurs, contrairement à la technique antérieure d'implantation d'impuretés, il permet la réalisation de guides optiques ayant des propriétés optiques stables dans le temps et utilisables pour toutes les polarisations de la lumière.

De façon plus précise, l'invention a pour objet un procédé pour augmenter localement les indices de réfraction d'un matériau monocristallin ferro-électrique, caractérisé en ce qu'il comprend (a) au moins une implantation ionique de soufre ou d'un dopant métallique susceptible de prendre la place d'un cation du réseau cristallin du matériau, cette implantation étant effectuée sous vide, et (b) un recuit du matériau implanté, à une température allant de 300°C à 600°C, pour ré-arranger le réseau cristallin perturbé lors de l'implantation et activer les ions implantés, tout en évitant leur diffusion dans le matériau.

Le soufre est susceptible de prendre la place de l'anion du réseau cristallin du matériau ferro-électrique, lorsqu'il présente un degré d'oxydation négatif, et de prendre la place d'un cation dudit réseau, lorsqu'il présente un degré d'oxydation positif.

Ce procédé permet l'augmentation simultanée des différents indices de réfraction d'un matériau monocristallin, et ce, sur une très faible profondeur contrairement à la diffusion de dopants. En outre, le profil d'indice obtenu est uniforme et très localisé, avec une amplitude plus élevée que celle obtenue avec la technique de diffusion. En effet, le but recherché par l'invention est d'obtenir une forte concentration de dopants dans une faible épaisseur du matériau monocristallin, ce qui n'est pas possible par la diffusion thermique classique. L'implantation ionique permet au contraire de se placer hors équilibre thermodynamique.

L'implantation ionique de dopant métallique ou de soufre selon l'invention crée des défauts à l'intérieur du matériau monocristallin conduisant, dans un premier temps, à un abaissement des indices du matériau monocristallin. Le recuit entre 300 et 600°C permet de guérir ces défauts d'implantation entraînant une compensation de cette diminution des indices de réfraction lors de l'implantation, puis d'augmenter ces indices de réfraction grâce à une activation des ions implantés. Cette activation consiste en un placement des dopants implantés en position substitutionnelle dans des sites et/ou dans les lacunes du réseau cristallin nouvellement ordonné.

L'augmentation des indices de réfraction résultants augmente avec la température de recuit dans la gamme de température considérée, contrairement à ce qui est obtenu avec les implantations d'impuretés conformément à l'art antérieur.

Les ions dopants implantés selon l'invention doivent présenter les propriétés suivantes :
– augmenter la polarisabilité électronique du matériau ferro-électrique dans la gamme de longueur d'onde envisagée pour l'utilisation du guide optique (visible au proche infrarouge), et/ou diminuer le volume de la maille cristalline,
– enfin, ne pas créer de bande d'absorption dans la gamme de transmission de la lumière visée.

Conformément à l'invention, la température de recuit va de 300 à 600°C. En effet, une température inférieure à 300°C ne permet que la guérison des défauts créés dans le matériau cristallin lors de l'implantation, l'activation des ions implantés n'ayant pas lieu.

En outre, bien qu'une température supérieure à 600°C pourrait être utilisée en vue d'augmenter le plus possible les indices de réfraction, une température trop élevée entraînerait une diffusion trop importante des ions implantés à l'intérieur du matériau annihilant les effets recherchés par l'implantation (saut d'indice). Par ailleurs, une augmentation de la température au-dessus de 600°C peut conduire, suivant le matériau utilisé, à une décomposition en surface de celui-ci et/ou à une perte de ses propriétés électro-optiques par désorientation des moments dipolaires, lors du recuit à une température supérieure à la température de Curie.

Avantageusement, le recuit est réalisé sous atmosphère d'oxygène afin d'éviter une réduction en surface du monocristal.

Afin d'améliorer l'efficacité de l'implantation, il est possible de réaliser pendant l'implantation un chauffage modéré du matériau ou, à l'inverse, un refroidissement pouvant aller jusqu'à la température de l'azote liquide (77°K) suivant le dopant et/ou le matériau monocristallin utilisé. Il est aussi possible de réaliser l'implantation à température ambiante.

Afin d'obtenir le maximum d'ions implantés dans un minimum de volume, on réalise avantageusement l'implantation des ions selon une direction inclinée par rapport à la normale à la surface du matériau monocristallin. Ceci permet, compte tenu de l'arrangement des ions du réseau cristallin, de créer des obstacles aux ions implantés empêchant ainsi leur implantation trop profondément dans le matériau monocristallin. Cet angle d'inclinaison doit être différent de zéro, par exemple égal à 7°.

Comme matériaux monocristallins ferro-électriques auxquels se rapporte l'invention, on peut citer les céramiques ou oxydes mixtes de niobium, de tantale, de titane, de baryum, etc. On peut par exemple utiliser le niobate de lithium ($LiNbO_3$), le tantalate de lithium ($LiTaO_3$), le titanate de baryum ($BaTiO_3$), le niobate de strontium et de baryum ($Ba_2SrNb_5O_{15}$), le niobate de potassium ($KNbO_3$), le niobate de baryum

et de sodium ($Ba_2NaNb_5O_{15}$).

De préférence, on utilise le niobate de lithium ou tantalate de lithium.

Conformément à l'invention, les ions dopants sont des ions métalliques et en particulier des ions de métaux de transition susceptibles de prendre la place d'un cation du réseau cristallin du matériau ferro-électrique, ou les ions du soufre susceptibles de prendre la place de l'anion du réseau cristallin ou du cation suivant son degré d'oxydation.

Dans le cas d'un monocristal en niobate de lithium, on peut utiliser des ions susceptibles de se substituer aux ions $Nb^{5+}$, comme par exemple les ions du titane, du vanadium, du nickel, du fer, du cobalt, du zirconium, du zinc, du tantale, du chrome ou bien les ions du niobium, du cuivre, de l'or, du titane ou de l'argent susceptibles de se substituer aux ions $Li^+$.

Dans le cas d'un monocristal en tantalate de lithium, on peut utiliser des ions susceptibles de se substituer aux ions du tantale comme par exemple les ions du titane ou du niobium ou bien des ions comme le titane ou le cuivre susceptibles de se substituer aux ions $Li^+$.

De préférence, on utilise le titane pour un monocristal en niobate ou tantalate de lithium.

Dans le cas d'un monocristal en niobate de baryum et de strontium, on peut utiliser des ions susceptibles de se substituer au niobium ou au strontium comme par exemple les ions de titane ou de vanadium ou bien l'ion soufre pour une substitution de l'oxygène.

Le procédé selon l'invention s'applique en particulier à la réalisation d'un guide optique plan ou ruban. Dans ce cas, on effectue une ou plusieurs implantations successives d'un même dopant pour former la couche guidante du guide optique. Le nombre d'implantations dépend de l'épaisseur de la couche guidante que l'on désire obtenir ; dans le cas de plusieurs implantations, les énergies et les doses sont successivement modifiées de façon à obtenir des distributions plates de dopants souhaités.

Le procédé selon l'invention s'applique aussi à un matériau monocristallin comportant une couche guidante susceptible de véhiculer un signal lumineux. Dans ce cas, on effectue l'implantation d'ions dans ou au voisinage de la couche guidante en vue d'en modifier ses propriétés de guidage, par exemple pour la réalisation d'un réseau d'indice superposé à la couche guidante.

Les énergies d'implantation sont comprises avantageusement entre 100 keV et 2 MeV ; plus l'énergie d'implantation est élevée, plus la zone du matériau implantée est profonde. Une énergie d'implantation inférieure à 100 keV n'est pas suffisante pour permettre une pénétration suffisante des ions tandis qu'une énergie d'implantation supérieure à 2 MeV risquerait d'endommager le matériau monocristallin.

Les augmentations des indices du matériau monocristallin augmentent avec la dose d'ions implantés. Pour obtenir une variation d'indice suffisante (d'au moins 5%), on utilise des doses d'implantation comprises entre $10^{15}$ et $10^{17}$ ions/cm², et de préférence dans l'intervalle allant de $5 \cdot 10^{15}$ à $5 \cdot 10^{16}$ ions/cm². Une dose d'implantation supérieure à $10^{17}$ ions/cm² entraînerait une destruction partielle du matériau.

Dans le cas particulier d'un monocristal en $LiNbO_3$ et d'ions dopants de titane, l'augmentation de l'indice de réfraction ordinaire est d'au moins +0,1, l'indice ordinaire du monocristal pur étant de l'ordre de 2,2.

D'autres caractéristiques et avantages de l'invention ressortiront mieux de la description qui va suivre, donnée à titre illustratif et non limitatif en référence aux figures annexées dans lesquelles :

　　– la figure 1a illustre la réalisation d'un guide optique plan grâce au procédé selon l'invention dans du $LiNbO_3$ et la figure 1b donne le profil de l'indice de réfraction ordinaire du guide obtenu,

　　– la figure 2 illustre le profil de l'indice de réfraction ordinaire d'un guide optique plan obtenu par diffusion dans un monocristal, conformément à l'art antérieur,

　　– la figure 3 donne la profondeur d'implantation en fonction de l'énergie d'implantation conforme à l'invention,

　　– la figure 4 donne les variations ($dn_o$) de la différence des indices de réfraction ordinaire de la couche implantée et du matériau non dopé en fonction de la dose d'ions implantés, conformément à l'invention,

　　– la figure 5 donne les variations ($dn_o$) de la différence d'indices de réfraction ordinaire entre la couche implantée et le matériau non dopé en fonction de la température de recuit ; la courbe I est relative à l'invention et les courbes II et III relatives à une implantation d'impuretés selon l'art antérieur,

　　– la figure 6 illustre les variations du volume du monocristal implanté, par rapport au monocristal non implanté, en fonction de la température de recuit du monocristal implanté,

　　– la figure 7 illustre schématiquement, en perspective, la réalisation d'un guide optique ruban grâce au procédé selon l'invention,

　　– la figure 8 illustre schématiquement, en perspective, la réalisation d'un réseau de diffraction par le procédé conforme à l'invention, et

　　– la figure 9 représente, en perspective, un guide optique courbé, obtenu par le procédé selon l'invention.

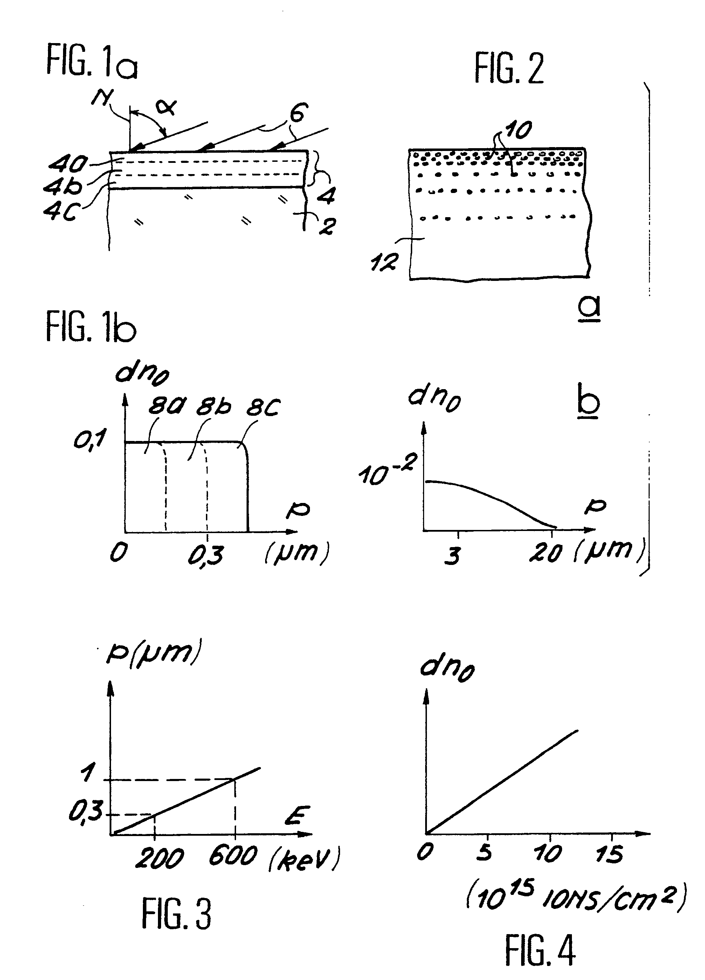

La réalisation d'un guide plan selon l'invention consiste, en référence à la figure 1a, à effectuer dans un monocristal ferro-électrique 2, par exemple en niobate de lithium, une multi-implantation d'un dopant métallique par exemple de titane, conduisant à l'obtention d'une couche superficielle 4 implantée, présentant des indices de réfraction ordinaire et extraordinaire supérieurs à ceux du substrat 2 non implanté. L'implantation est effectuée dans une enceinte à vide où règne une pression d'environ $5 \times 10^{-7}$ Torr ($5 \times 10^{-5}$ Pa).

Cette implantation est réalisée à l'aide d'un faisceau 6 de $Ti^+$ provenant de l'ionisation d'une vapeur de $TiCl_4$. Ce faisceau d'ions forme un angle $\alpha$ par rapport à la normale N à la surface du monocristal, voisin de 7°. Cette inclinaison peut être obtenue en disposant le monocristal sur un support incliné dont la surface forme un angle $\alpha$ par rapport à l'horizontale.

Ensuite, on effectue un recuit au four, pendant 60 min, à une température allant de 300 à 600°C et par exemple de 400°C, sous un flux d'oxygène de 1 litre/min à la pression atmosphérique.

Pour obtenir une épaisseur suffisante de la couche guidante 4 afin de permettre le transport d'un signal lumineux dans cette couche, on effectue selon l'invention plusieurs implantations successives de titane, avec des énergies croissantes et des doses d'implantation appropriées pour obtenir le profil souhaité.

Par exemple pour l'obtention d'une couche 4 de 0,7 micromètre, on effectue une première implantation de titane 22 une énergie de 100 keV conduisant à l'obtention d'une couche de surface 4a de 0,1 micromètre d'épaisseur, suivie d'une seconde implantation de titane à une énergie de 200 keV permettant d'obtenir une augmentation des indices de réfraction dans une couche 4b, adjacente à la couche 4a, allant jusqu'à une profondeur de 0,3 micromètre, suivie d'une troisième implantation à une énergie de 500 keV entraînant la formation d'une couche 4c, adjacente à la couche 4b, située à une profondeur de 0,7 micromètre dans le monocristal.

Ces implantations successives permettent d'obtenir un profil d'indices plan et donc un guide optique à saut d'indice, avec une augmentation des indices ordinaire et extraordinaire plus forte que celle obtenue par la technique de diffusion selon l'art antérieur.

A cet effet, on a représenté sur la figure 1b les variations de la différence d'indice de réfraction ordinaire ($dn_o$) entre la couche guidante et le matériau non dopé en fonction de la profondeur (P) d'implantation, exprimée en micromètres. Les courbes 8a, 8b et 8c représentent respectivement les variations de $dn_o$ dans les couches implantées 4a, 4b, 4c.

Les variations de la différence des indices extraordinaires entre la couche guidante et le matériau non dopé sont similaires.

Le procédé selon l'invention permet la réalisation d'un guide d'onde à saut d'indice de faible épaisseur, contrairement au procédé utilisant la diffusion qui, comme représenté sur la figure 2, donne un guide d'onde à faible gradient d'indice sur une grande profondeur, voisine de 20 micromètres. La partie a illustre la diffusion des ions de titane 10 dans un monocristal 12 de $LiNbO_3$ et la partie b donne les variations de l'indice ordinaire ($dn_o$) en fonction de la profondeur (P), exprimée en micromètres, du monocristal. Le guide optique a été formé en déposant une couche de titane de 85 nm d'épaisseur sur la surface du monocristal puis en portant l'ensemble à 1000°C pendant 16 heures.

Comme on l'a dit précédemment, la profondeur d'implantation est directement proportionnelle à l'énergie d'implantation des ions. Ceci ressort clairement de la courbe représentée sur la figure 3 donnant la profondeur d'implantation (P), exprimée en micromètres, en fonction de l'énergie d'implantation (E), exprimée en keV.

Conformément à l'invention, la réalisation d'un guide de surface par multi-implantation nécessite l'emploi d'un même dopant et des doses d'implantation augmentant en même temps que l'énergie.

Les doses d'implantation utilisées dépendent de l'augmentation des indices de réfraction que l'on désire obtenir dans le monocristal. En effet, comme représenté sur la figure 4, l'indice ordinaire (et extraordinaire) du matériau implanté croît linéairement en fonction de la dose d'ions implantés par centimètre carré.

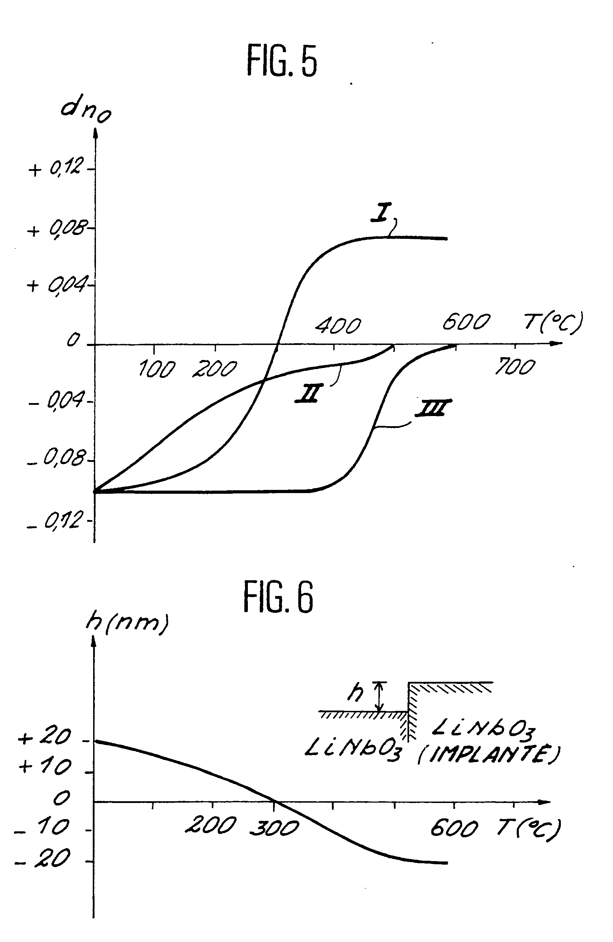

Par ailleurs, la valeur des indices ordinaire et extraordinaire obtenus dans la couche implantée croît avec la température de recuit. A cet effet, on a représenté sur la figure 5, les variations de $dn_o$ en fonction de la température de recuit, exprimée en °C.

La courbe I concerne une implantation de titane conformément à l'invention dans du niobate de lithium, à une dose de $10^{16}$ atomes/cm² et une énergie de 190 keV. La courbe II est relative à l'implantation d'ions de bore à une dose de $2.10^{16}$ ions/cm², avec une énergie d'implantation comprise entre 120 et 140 keV, et la courbe III est relative à une implantation d'ions de néon, à une dose de $5.10^{15}$ ions/cm² et une énergie comprise entre 120 et 140 keV.

La courbe I comporte une partie située en-dessous de l'axe des abscisses jusqu'à la température de 300°C, puis une partie située au-dessus de cet axe. A partir de 300°C, l'indice de réfraction ordinaire de la couche implantée et donc la différence d'indice $dn_o$ entre la couche implantée et le reste du monocristal augmente avec la température de recuit.

En revanche, la différence des indices de réfraction ordinaires entre la couche implantée selon l'art antérieur et le monocristal diminue avec la température de recuit jusqu'à s'annuler vers 500°C pour la courbe II et vers 600°C pour la courbe III.

La partie négative de la courbe I correspond, comme pour les courbes II et III, à un désordre cristallin induit par l'implantation.

La partie positive de la courbe I correspond à l'activation des ions de titane implantés, grâce au recuit, qui correspond à la substitution partielle des ions Nb ou Li par les ions Ti et/ou au remplissage des lacunes du monocristal ; les ions titane sont alors dans les sites du réseau cristallin.

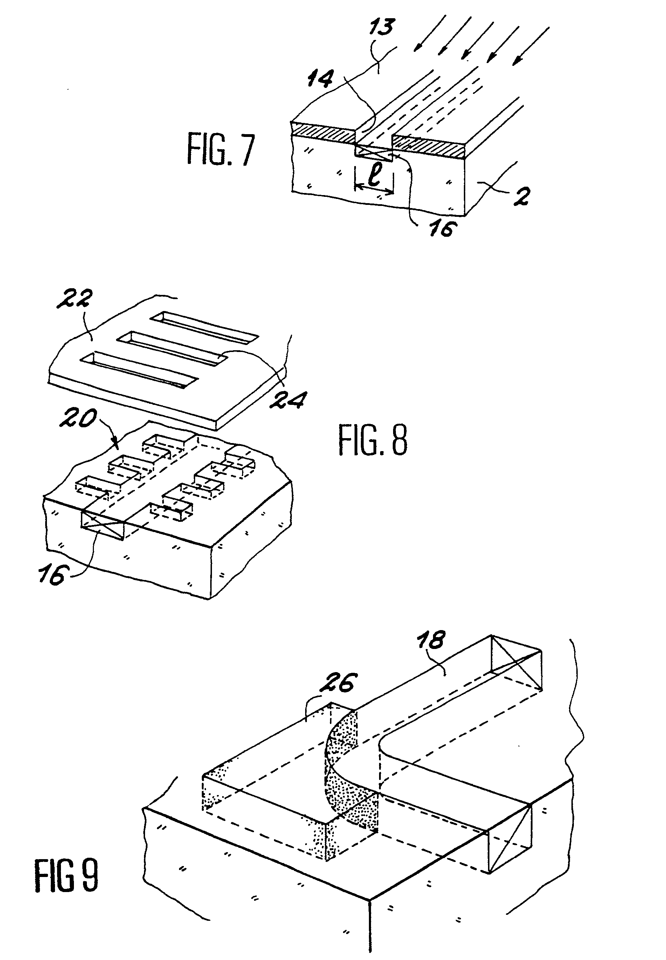

La figure 6 donnant les variations de la hauteur (h), exprimée en nm, séparant la surface du matériau implanté et celle du matériau non implanté, en fonction de la température de recuit exprimée en °C, est aussi repésentative de l'activation des ions implantés par le recuit.

La partie positive de la courbe, correspondant à une augmentation du volume du monocristal, résulte du désordre du matériau implanté, alors que la partie négative, correspondant à une diminution du volume du monocristal résulte du positionnement en site cationique ou lacunaire du titane. Le changement de polarité de la courbe a lieu, comme pour la courbe I de la figure 5, à 300°C.

Sur la figure 7, on a représenté la réalisation conforme à l'invention, d'un guide optique ruban. Pour définir l'emplacement et la largeur de la couche guidante, on réalise à la surface supérieure du monocristal 2 de niobate de lithium par exemple un masque 13 comportant une ouverture 14 définissant la largeur I de la couche guidante à réaliser.

Ce masque peut être un masque de résine photosensible, ou bien un masque métallique, par exemple en or, formé de façon connue par photolithographie. On effectue alors une multi-implantation d'ions de titane telle que décrite en référence à la figure 1a.

Après élimination du masque 13 par attaque chimique, on réalise un recuit compris entre 300 et 600°C.

On obtient alors une couche guidante 16 d'indices de réfraction ordinaire et extraordinaire supérieurs à ceux du monocristal non implanté, située en regard de l'ouverture 14 du masque 13.

Suivant la forme de l'ouverture 14 du masque, on peut réaliser une couche guidante de n'importe quelle forme, par exemple une couche guidante de forme parallélépipédique comme représentée sur la figure 7 ou bien comme représentée sur la figure 9, une couche guidante courbée 18. La forme de la couche guidante dépend du circuit optique intégré que l'on désire réaliser.

Afin de modifier les propriétés de guidage de la couche guidante, on peut réaliser une autre implantation de titane, en vue d'augmenter localement l'indice de réfraction de cette couche guidante.

On peut par exemple réaliser, comme représenté sur la figure 8, un réseau de diffraction 20 dans la couche guidante 16 en vue par exemple de sélectionner un signal lumineux particulier véhiculé avec plusieurs autres signaux par la couche guidante 16.

Ce réseau de diffraction 20 est réalisé en formant un nouveau masque d'implantation 22 à la surface du monocristal comportant des ouvertures 24, de forme longitudinale, parallèles entre elles, définissant l'emplacement et les dimensions des fentes du réseau, et donc le pas de ce réseau.

A travers ce masque 22, on réalise alors une implantation d'ions de titane à une dose de $5.10^{16}$ ions/cm$^2$ et une énergie de 100 keV. Cette implantation est réalisée, conformément à l'invention, avec un faisceau d'ions formant un angle de 7° environ par rapport à la normale à la surface du monocristal.

Après élimination du masque 22, on réalise un nouveau recuit du matériau à une température comprise entre 300 et 600°C.

Dans le cas d'un guide optique courbé, tel que représenté sur la figure 9, on peut réaliser une modification locale 26 de l'indice de réfraction du monocristal, à l'extérieur du coude de la couche guidante 18, afin de diminuer les pertes de propagation de la lumière transmise par ce guide courbe.

Cette modification locale 26 est encore réalisée en implantant, selon une direction inclinée, à travers un masque d'implantation de forme appropriée, des ions de titane à une dose de $10^{16}$ ions/cm$^2$ et une énergie de 190 keV, suivie d'un recuit entre 300 et 600°C, conduisant à une augmentation des indices ordinaire et extraordinaire du monocristal de $5.10^{-2}$ sur environ 0,3 micromètre.

Dans le cas de la réalisation d'une perturbation locale, du type de celle représentée sur les figures 8 et 9, il est possible de réaliser la couche guidante par diffusion de titane, conformément à l'art antérieur, lorsque l'on désire obtenir un guide optique à gradient d'indice.

Comme autre type de perturbations locales d'un guide optique, réalisable selon l'invention, on peut citer l'amélioration de l'interaction de la lumière avec un champ électrique appliqué à l'intérieur de la couche guidante par exemple à l'aide d'électrodes situées de part et d'autre de cette couche guidante, en rapprochant le mode guidé de la surface de la couche guidante grâce à une augmentation locale des indices de réfraction à la surface de cette couche guidante. Ceci est notamment utilisé pour la réalisation d'un modulateur électro-optique.

D'autres applications du procédé selon l'invention peuvent être envisagées sans pour autant sortir du cadre de l'invention.

Les propriétés des guides et des composants optiques obtenus par le procédé de l'invention ont été régulièrement contrôlées ; après une période d'essai d'un an, aucune modification de ces propriétés n'a été décelée.

## Revendications

1. Procédé pour augmenter localement les indices de réfraction d'un matériau monocristallin ferro-électrique, caractérisé en ce qu'il comprend (a) au moins une implantation ionique (6) de soufre ou d'un dopant métallique susceptible de prendre la place d'un cation du réseau cristallin du matériau (2), cette implantation étant réalisée sous vide, et (b) un recuit du matériau implanté, à une température allant de 300°C à 600°C, pour ré-arranger le réseau cristallin perturbé lors de l'implantation et activer les ions implantés, tout en évitant leur diffusion dans le matériau (2).

2. Procédé selon la revendication 1, caractérisé en ce que l'on implante les ions selon une direction inclinée ($\alpha$) par rapport à la normale (N) à la surface du matériau (2).

3. Procédé selon la revendication 2, caractérisé en ce que l'inclinaison est voisine de 7°.

4. Procédé selon l'une quelconque des revendications 1 à 3, caractérisé en ce que le matériau (2) est choisi parmi le niobate de lithium, le tantalate de lithium, le titanate de baryum, le niobate de strontium et de baryum, le niobate de potassium et le niobate de baryum et de sodium.

5. Procédé selon la revendication 4, caractérisé en ce que le dopant métallique est un ion d'un métal de transition.

6. Procédé selon la revendication 4 ou 5, caractérisé en ce que le dopant métallique est choisi parmi le titane, le vanadium, le nickel, le fer, le cobalt, l'argent, l'or, le niobium, le tantale, le chrome, le cuivre, le zinc et le zirconium.

7. Procédé selon la revendication 1, caractérisé en ce que le matériau (2) est le niobate de lithium ou le tantalate de lithium et le dopant est le titane.

8. Procédé selon l'une quelconque des revendications 1 à 7, caractérisé en ce que le recuit est réalisé en atmosphère d'oxygène.

9. Procédé selon l'une quelconque des revendications 1 à 8, appliqué à la réalisation d'un guide optique.

10. Procédé selon la revendication 9, caractérisé en ce que l'on effectue au moins deux implantations successives dudit dopant, à des doses et à des énergies différentes pour former le guide optique (figure 7).

11. Procédé selon l'une quelconque des revendications 1 à 8, appliqué à un matériau comportant une couche guidante (16, 18) susceptible de véhiculer un signal lumineux, caractérisé en ce que l'on effectue l'implantation d'ions dans ou au voisinage de ladite couche guidante (16, 18).

12. Procédé selon l'une quelconque des revendications 1 à 11, caractérisé en ce que les énergies sont comprises entre 100 keV et 2 MeV.

13. Procédé selon l'une quelconque des revendications 1 à 12, caractérisé en ce que les doses varient de $5 \cdot 10^{15}$ à $5 \cdot 10^{16}$ ions/cm$^2$.

14. Matériau monocristallin ferro-électrique comportant localement une augmentation des indices de réfraction obtenue par le procédé selon l'une quelconque des revendications 1 à 13, caractérisé en ce que l'augmentation des indices est d'au moins 5%.

## Ansprüche

1. Verfahren zum lokalen Erhöhen der Brechungsindizes eines einkristallinen, ferroelektrischen Materials, dadurch gekennzeichnet, daß es (a) wenigstens eine Ionenimplantation (6) von Schwefel oder eines metallischen Dotierstoffes, der geeignet ist, die Stelle eines Kations des Kristallgitters des Materials (2) einzunehmen, wobei diese Implantation unter Vakuum durchgeführt wird, und (b) ein Ausglühen des implantierten Materials bei einer Temperatur von 300°C bis 600°C umfaßt, um das durch die Implantation gestörte Gitter wiederherzustellen und die implantierten Ionen zu aktivieren, wobei das alles unter Vermeidung ihrer Diffusion in das Material (2) geschieht.

2. Verfahren nach Anspruch 1, dadurch gekennzeichnet, daß man die Ionen in einer bezüglich der Normalen (N) der Oberfläche des Materials (2) geneigten Richtung (a) implantiert.

3. Verfahren nach Anspruch 2, dadurch gekennzeichnet, daß die Neigung nahe bei 7° liegt.

4. Verfahren nach einem der Ansprüche 1 bis 3, dadurch gekennzeichnet, daß das Material (2) ausgewählt wird dem dem Lithiumniobat, dem Lithiumtantalat, dem Bariumtitanat, dem trontium- und dem Bariumniobat, dem Kallumniobat und dem Barium- und Natriumniobat.

5. Verfahren nach Anspruch 1, dadurch gekennzeichnet, daß der metallische Dotierstoff ein Ion eines ubergangsmetalls ist.

6. Verfahren nach Anspruch 4 oder 5, dadurch gekennzeichnet, daß der metallische Dotierstoff ausgewählt aus dem Titan, dem Vanadium, dem Nickel, dem Eisen, dem Kobalt, dem Silber, dem Gold, dem Niob, dem Tantal, dem Chrom, dem Kupfer, dem Zink und dem Zirkon.

7. Verfahren nach Anspruch 1, dadurch gekennzeichnet, daß das Material (2) das Lithiumniobat oder das Lithiumtantalat und der Dotierstoff das Titan ist.

8. Verfahren nach einem der Ansprüche 1 bis 7, dadurch gekennzeichnet, daß das Ausglühen in einer Sauerstoffatmosphäre durchgeführt wird.

9. Verfahren nach einem der Ansprüche 1 bis 8, dadurch gekennzeichnet, daß es zur Herstellung eines optischen Wellenleiters verwendet wird.

10. Verfahren nach Anspruch 9, dadurch gekennzeichnet, daß man wenigstens zwei aufeinander folgende Implantationen des Dotierstoffs mit verschiedenen Dosen und Energien durchführt, um don optischen Wellenleiter herzustellen (Figur 7).

11. Verfahren nach einem der Ansprüche 1 bis 8 auf ein Material angewandt, das eine Führungsschicht (16, 18) aufweist, die geeignet ist, ein Lichtsignal zu übertragen, dadurch gekennzeichnet, daß man die Ionenimplantation in oder in der Nähe der Führungsschicht (16, 18) durchführt.

12. Verfahren nach einem der Ansprüche 1 bis 11, dadurch gekennzeichnet, daß die Energien zwischen 100 keV und 2 MeV liegen.

13. Verfahren nach einem der Ansprüche 1 bis 12, dadurch gekennzeichnet, daß die Dosen von $5 \cdot 10^{15}$ bis $5 \cdot 10^{16}$ Ionen/cm$^2$ variieren.

14. Einkristallines, ferroelektrisches Material mit einer lokalen Erhöhung der Brechungsindizes, wie es nach dem Verfahren nach einem der Ansprüche 1 bis 13 hergestellt wird, dadurch gekennzeichnet, daß die Erhöhung der Brechungsindizes wenigstens 5% beträgt.

## Claims

1. Process for locally increasing the refractive indexes of a ferroelectric monocrystalline material, characterized in that it comprises (a) at least one ion implantation (6) of sulphur or a metallic dopant liable to take the place of a cation of the crystal lattice of the material (2), said implantation taking place in vacuum and (b) an annealing of the implanted material at a temperature of 300 to 600°C, in order to rearrange the crystal lattice disturbed during implantation and activate the implanted ions, whilst preventing the diffusion thereof into material (2).

2. Process according to claim 1, characterized in that the ions are implanted in an inclined direction ($\alpha$) with respect to the normal (N) to the surface of material (2).

3. Process according to claim 2, characterized in that the inclination is close to 7°.

4. Process according to claim 1, characterized in that the material (2) is chosen from among lithium niobate, lithium tantalate, barium titanate, strontium and barium niobate, potassium niobate and barium and sodium niobate.

5. Process according to claim 4, characterized in that the metallic dopant is an ion of a transition metal.

6. Process according to claim 4, characterized in that the metallic dopant is chosen from among titanium, vanadium, nickel, iron, cobalt, silver, gold, niobium, tantalum, chromium, copper, zinc and zirconium.

7. Process according to claim 1, characterized in that the material (2) is lithium niobate or lithium tantalate and the dopant is titanium.

8. Process according to claim 1, characterized in that annealing is carried out in an oxygen atmosphere.

9. Process according to claim 1, applied to the production of an optical guide.

10. Process according to claim 9, characterized in that there are at least two successive implantations of said dopant at different doses and energies in order to form the optical guide (Fig. 7).

11. Process according to claim 1, applied to a material having a guide layer (16, 18) able to carry a light signal, characterized in that the implantation of the ions takes place in or in the vicinity of said guide layer (16, 18).

12. Process according to claim 1, characterized in that the energies are between 100 keV and 2 MeV.

13. Process according to claim 1, characterized in that the doses vary from $5 \cdot 10^{15}$ to $5 \cdot 10^{16}$ ions/cm$^2$.

14. Ferroelectric monocrystalline material locally having an increase in the refractive indices obtained by the process according to claim 1, characterized in that the increase in the indices is at least 5%.

## FIG. 1a

## FIG. 2

## FIG. 1b

## FIG. 3

## FIG. 4

$(10^{15}$ IONS/cm²$)$

## FIG. 5

## FIG. 6

FIG. 7

FIG. 8

FIG 9